# EUROPÄISCHE PATENTANMELDUNG

(11) **EP 0 969 708 A2**
(43) Veröffentlichungstag der Anmeldung: **05.01.2000**
(21) Anmeldenummer: 99102608.9
(22) Anmeldetag: 11.02.1999
(51) Int. Cl.: H05K 5/00

(54) **Gehäuse**

(30) Priorität: 30.06.1998 DE 19829028
(71) Anmelder: ROBERT BOSCH GMBH, 70442 Stuttgart (DE)
(72) Erfinder: Scholz, Friedrich, 01900 Bretnig-Hauswalde (DE); Merker, Eckart, 01477 Arnsdorf (DE)

(57) **Zusammenfassung**

Ein Gehäuse umfassend ein Bodenteil und ein Deckelteil, die durch Rastelemente miteinander verbindbar sind, ist dadurch gekennzeichnet, daß die Rastelemente an im Innern des Gehäuses angeordneten Wandelementen (Innenwänden) ausgebildet sind und in dafür vorzugsweise an einer Außenwand des Gehäuses vorgesehene Ausnehmungen, eingreifen.

## Beschreibung

### Stand der Technik

Die Erfindung betrifft ein Gehäuse umfassend ein Bodenteil und ein Deckelteil, die durch Rastelemente miteinander verbindbar sind.

Derartige Gehäuse bestehen in den meisten Fällen aus einem Kunststoffmaterial und dienen der Aufnahme von elektrischen oder elektronischen Geräten mit integrierten Netzteilen.

Bekannte Gehäuse werden mit zusätzlichen Verbindungs- oder Sicherungselementen in Form von zum Beispiel Schrauben, Klebverbindungen, Schweißverbindungen oder Nietverbindungen versehen, um äußeren mechanischen Belastungen standzuhalten. Dabei muß das Gehäuse äußeren mechanischen Belastungen nach DIN EN60950,4.2.x standhalten, ohne daß ein Öffnen oder eine Zerstörung der Verriegelung auftritt. Das Gehäuse muß darüber hinaus ohne Zerstörung der Verriegelung geöffnet werden können.

Ferner sind Gehäuse bekannt, die mit Snap-in-Verbindungen versehen sind, die an der Gehäusewand angreifen und damit direkt Belastungen ausgesetzt sind, so daß die Verriegelung selbsttätig durch solche Belastungen geöffnet oder zerstört wird. Dies kann nur dadurch verhindert werden, daß die Verriegelung so stabil ausgelegt wird, daß ein Öffnen ohne Zerstörung der Verriegelung oder Teilen des Gehäuses nicht möglich ist.

Außerdem werden in vielen Fällen zur Sicherung gegen unbeabsichtigtes und unbefugtes Öffnen des Gehäuses auch Plomben als Beilegeteile hinzugefügt, deren Wirkung nicht sicher ist, weil diese manuell eingebracht werden müssen.

Aufgabe der Erfindung ist es, ein gattungsgemäßes Gehäuse, das nur durch eine Snap-in-Verbindung verriegelt wird, derart weiterzubilden, daß es hohe äußere mechanische Belastungen ohne unbeabsichtigtes Öffnen oder eine Zerstörung der Verriegelung aufnehmen kann und daß es ohne Zerstörung der Verriegelung nur mit Werkzeug geöffnet werden kann. Darüber hinaus soll das Gehäuse eine Plombierung zum erkennbaren Öffnen aufweisen.

### Vorteile der Erfindung

Diese Aufgabe wird erfindungsgemäß dadurch gelöst, daß die Rastelemente an im Innern des Gehäuses angeordneten Wandelementen (Innenwänden) ausgebildet sind und in dafür vorzugsweise an einer Außenwand des Gehäuses vorgesehene Ausnehmungen eingreifen.

Durch die Anordnung der Rastelemente an einer Innenwand wird auf besonders vorteilhafte Weise ausgeschlossen, daß die Verriegelung direkten äußeren Belastungen ausgesetzt ist, wie es beispielsweise bei an der Gehäuseaußenwand angeordneten Verriegelungselementen der Fall ist. Darüber hinaus wird durch diese Anordnung eine gleichmäßige Kraftaufnahme der beiden Gehäuseteile, des Boden- und des Deckelteils, auf weiter unten noch näher zu beschreibende Weise realisiert.

Um Deformationen des Boden- und/oder Deckelteils und ein dadurch eventuell hervorgerufenes unerwünschtes Öffnen der Rastverbindungen auszuschließen, ist vorteilhafterweise vorgesehen, daß im Gehäuseinneren an dem Boden- und Deckelteil Rippenelemente angeordnet sind, die im geschlossenen Zustand des Gehäuses ineinander eingreifen. Durch diese Rippenelemente wird zum einen eine Stabilisierung des Boden- und Deckelteils und zum anderen ein Abfangen und Ableiten von Deformationskräften ermöglicht.

Die Rastelemente sind vorteilhafterweise Rasthaken, die in zu diesen im wesentlichen komplementär ausgebildeten Formelementen federnd eingreifen. Dabei ist vorteilhafterweise vorgesehen, daß die Rasthaken durch biegbare Zungen gegen eine werkzeuglose Entriegelung gesichert sind. Hierdurch läßt sich auf einfache Weise eine Plombierung realisieren. Darüber hinaus ist sichergestellt, daß das Gehäuse nur mit Werkzeug geöffnet werden kann.

### Zeichnung

Weitere Vorteile und Merkmale der Erfindung sind Gegenstand der nachfolgenden Beschreibung sowie der zeichnerischen Darstellung eines Ausführungsbeispiels der Erfindung.

In der Zeichnung zeigen:
- Fig. 1: schematisch in dreidimensionaler Darstellung ein von der Erfindung Gebrauch machendes Gehäuse mit einem Boden- und einem Deckelteil;
- Fig. 2: in Draufsicht und teilweise geschnitten schematisch eine Rastverbindung des in Fig. 1 dargestellten Gehäuses und
- Fig. 3: eine in Fig. 2 entlang der Linie III-III geschnittene Schnittdarstellung der in Fig. 2 dargestellten Rastverbindung.

### Beschreibung eines Ausführungsbeispiels

Ein Gehäuse weist ein Deckelteil 1 und ein Bodenteil 8 auf. Im Deckelteil 1 sind Kammern 2 angeordnet, die durch die vordere Außenwand 3 des Deckelteils 1 und im Innern durch eine Innenwand 4 verbunden sind und bei denen im Innern des Deckelteils 1 angeordnete Wandelemente (Innenwände) 5 zu lösbaren Rasthaken 6 verlängert sind. Durch diese Anordnung der Innenwände 4, 5 in dem Deckelteil 1 entsteht ein festes, Energie absorbierendes Element, das Belastungen von den Innenwänden 5 und somit von den Rasthaken 6 weitgehend fernhält.

Im Deckelteil 1 sind ferner Rippen 9 angeordnet, die in Rippen 10, die im Bodenteil 8 angeordnet sind, eingreifen, diese schon bei geringen Verformungen des Deckelteils 1 berühren und dadurch Belastungen des Deckelteils 1 auf das Bodenteil 8 kraftschlüssig übertragen.

Die Wand 4 greift ebenfalls in Rippen 11 ein, die im Bodenteil 8 angeordnet sind, so daß zu Deformationen führende Belastungen der Kammern 2 hierdurch zusätzlich im Bodenteil 8 abgefangen werden.

Durch eine große Überlappung von Berührungsflächen 12 zwischen dem Deckel- und dem Bodenteil werden auf das Deckelteil 1 wirkende Deformationskräfte ebenfalls auf das Bodenteil 8 übertragen, welches so steif ausgebildet ist, daß es diese Belastungen aufnehmen kann.

Durch die beschriebene Anordnung von Boden- und Deckelteil wird die Übertragung von Deformationen auf die Innenwände 5 und dadurch die Rasthaken 6, hervorgerufen durch Deformationen oder andere Belastungen des Deckelteils 1 und hierdurch ein Entriegeln vermieden. Eine hintere Verriegelung zwischen dem Deckelteil 1 und dem Bodenteil 8 weist an der Rückwand angeordnete Rasthaken 13 und mit diesen verriegelbare Formelemente 14 am Bodenteil 8 auf. Die hintere Verriegelung ist so ausgeführt, daß diese nicht ohne Entriegeln der Rasthaken 6 und Ankippen des Deckelteils 1 entriegelt werden kann. Die Ausbildung und Form der Rasthaken 6 kann durch den sehr geringen Lasteintrag von außen in die Rasthaken 6 in großen Grenzen frei gewählt werden und somit auf eine optimale Verriegelung und Entriegelung abgestimmt werden.

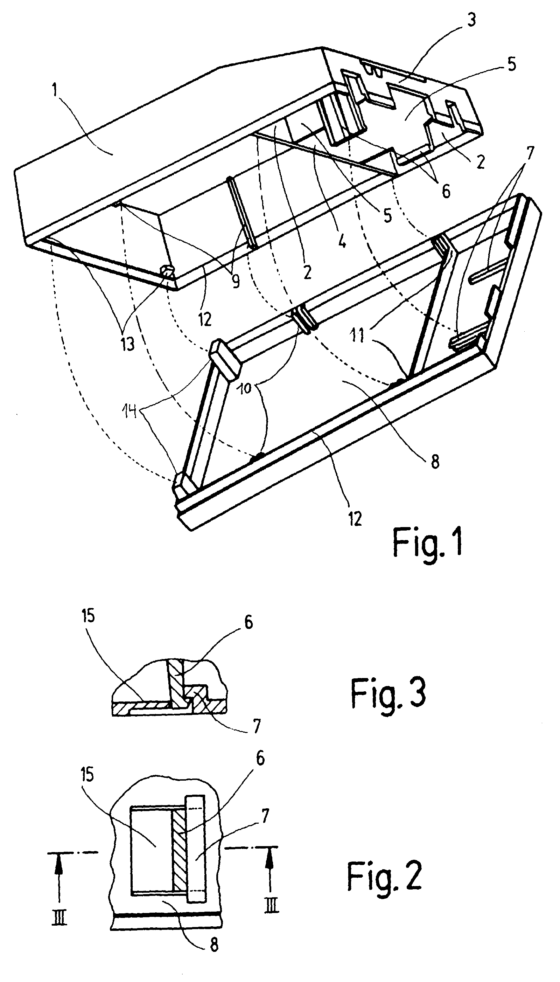

In Fig. 2 und Fig. 3 ist schematisch die Ausbildung der Rasthaken 6, die in Formelemente 7, die am Bodenteil 8 angeordnet sind, eingreifen, dargestellt. Wie aus Fig. 2 und Fig. 3 des weiteren hervorgeht, ist im Bodenteil 8 eine Verriegelung der Rasthaken 6 in Form von biegbaren Zungen 15 vorgesehen, so daß die Rasthaken 6 gegen ein Entriegeln aus den Formelementen 7, beispielsweise durch starke Deformation oder ohne Werkzeug gesichert sind. Beim Gleiten der Rasthaken über die Formelemente 7 während des Verriegelungsvorgangs wird die Zunge 15 durchgebogen, federt nach vollständiger Verriegelung der Rasthaken 6 zurück und sperrt so den Entriegelungsbereich der Rasthaken 6. Ein Entriegeln der Rasthaken ist abhängig von der Lage und den Abmessungen der Zungen durch ein Rückbiegen der Zungen 15 mit einem geeigneten Werkzeug oder durch eine Zerstörung der Zungen 15 (Plombierung) möglich.

## Patentansprüche

1. Gehäuse umfassend ein Bodenteil und ein Deckelteil, die durch Rastelemente miteinander verbindbar sind, dadurch gekennzeichnet, daß die Rastelemente an im Innern des Gehäuses angeordneten Wandelementen (Innenwänden) ausgebildet sind und in dafür vorzugsweise an einer Außenwand des Gehäuses vorgesehene Ausnehmungen, eingreifen.

2. Gehäuse nach Anspruch 1, dadurch gekennzeichnet, daß im Gehäuseinneren an dem Boden- und Deckelteil Rippenelemente angeordnet sind, die im geschlossenen Zustand des Gehäuses ineinandergreifen.

3. Gehäuse nach Anspruch 1 oder 2, dadurch gekennzeichnet, daß die Rastelemente Rasthaken sind, die in zu diesen im wesentlichen komplementär ausgebildete Formelemente federnd eingreifen.

4. Gehäuse nach Anspruch 3, dadurch gekennzeichnet, daß die Rasthaken durch biegbare Zungen gegen ein werkzeugloses Entriegeln gesichert sind.
